# EUROPÄISCHE PATENTSCHRIFT

(11) **EP 1 328 862 B1**
(45) Veröffentlichungstag und Bekanntmachung des Hinweises auf die Patenterteilung: **08.06.2005**
(21) Anmeldenummer: 01986784.5
(22) Anmeldetag: 15.10.2001
(51) Int. Cl.: G06F 5/06

(54) **SPEICHERKONFIGURATION MIT I/O-UNTERSTÜTZUNG**
MEMORY CONFIGURATION WITH I/O SUPPORT
CONFIGURATION DE MEMOIRE AVEC SUPPORT E/S

(30) Priorität: 13.10.2000 DE 10050980
(43) Veröffentlichungstag der Anmeldung: 23.07.2003
(73) Patentinhaber: Systemonic AG, 01099 Dresden (DE)
(72) Erfinder: DRESCHER, Wolfram, 01099 Dresden (DE); AUE, Volker, 01309 Dresden (DE)
(74) Vertreter: Adler, Peter, Dipl.-Ing.
(86) Internationale Anmeldenummer: PCT/DE2001/003916
(87) Internationale Veröffentlichungsnummer: WO 2002/031658

(56) Entgegenhaltungen:
- EP-A- 0 241 129
- DE-C- 19 526 798
- HALL J: "NEW FIFO ARCHITECTURE FOR HIGH PERFORMANCE APPLICATIONS" WESCON TECHNICAL PAPERS, WESTERN PERIODICALS CO. NORTH HOLLYWOOD, US, Bd. 33, 1. November 1989 (1989-11-01), Seiten 141-145, XP000115996
- LIN J S: "BIDIRECTIONAL FIFO IN THE PROCESSOR-TO-PERIPHERAL COMMUNICATIONS" WESCON TECHNICAL PAPERS, WESTERN PERIODICALS CO. NORTH HOLLYWOOD, US, Bd. 33, 1. November 1989 (1989-11-01), Seiten 131-136, XP000115994

## Beschreibung

Die Erfindung betrifft ein Verfahren zur Datenein- und -ausgabe bei einem Prozessor-Speicher, bei dem Daten aus einer Prozessor-Einheit in den Prozessor-Speicher geschrieben und aus diesem Prozessor-Speicher gelesen werden und die Daten über eine I/O-Einheit ein- und ausgegeben werden.

Die Erfindung betrifft weiterhin eine Anordnung zur Durchführung des oben genannten Verfahrens gemäß dem Oberbegriff des Anspruchs 4.

Aus der DE 195 26 798 C1 ist eine Anordnung zur Steuerung einer Datenübertragung sowie damit ein entsprechendes Verfahren bekannt. Darin wird die Dateneingabe in eine Datenverarbeitungseinrichtung über einen ersten Pufferspeicher und die Datenausgabe aus der Datenverarbeitungseinrichtung über einen zweiten Pufferspeicher realisiert. Die Adressierung beider Pufferspeicher erfolgt in beiden Fällen über die Datenverarbeitungseinrichtung. Dabei wird die Datenverarbeitungseinrichtung mit der Adressgenerierung belastet, was insbesondere bei der Anordnung mehrerer Prozessor-Einheiten in parallel arbeitenden Prozessoren, die jeweils eigene Ein- und Ausgaben generieren, zu einer die Rechenleistung minimierenden Belastung führt.

Aus Hall J: "NEW FIFO ARCHITECHTURE FOR HIGH PERFORMANCE APPLICATIONS" und aus Lin J S: BIDIRECTIONAL FIFO IN THE PROCESSOR-TO-PERIPHAL COMMUNICATIONS, beide in Wescon Technical Papers, Western Periodicals Co. North Hollywood, US Bd. 33, 1.11.1989, ist ein sogenannten BiFIFO (bidirektionales first-in-first-out Register) bekannt. Dieses BiFIFO besteht aus einem ersten Registerteil zu Pufferung der Daten bei der Dateneingabe in einen Processor und einem zweiten Registerteil zur Datenausgabe aus dem Register. Gesteuert werden die FIFO's über Flags, die einerseits das Weiterrücken der Werte in dem FIFO bewerkstelligen und andererseits Zustände steuern. Das Generieren der Flags geschieht entweder über den Prozessor oder eigenen *Generiereinheiten*. Damit erhöht sich die Prozessorbelastung, insbesondere im parallelen Betrieb, oder der schaltungstechnische Aufwand. Außerdem erlaubt der Einsatz von FIFO's als Puffer keinen adressierten Zugriff auf Daten. Damit bleibt der Einsatz auf die Anwendungsfälle beschränkt, bei denen die Daten zeitlich hintereinander liegend ein- oder ausgegeben werden. Einmal aus dem FIFO "herausgeschobene" Daten sind verloren.

Ebenfalls einen Einsatz von FIFO's als Pufferspeicher beschreibt die EP 0241 129 A2. Hierbei ist außerhalb des Prozessor-Speichers ein FIFO mit zwei Teilen vorgesehen, bei dem ein separater Controller (RBC) die Pufferung der Daten in einen jeweils bei Eingabe in den einen Teil und bei Ausgabe in den anderen Teil vorsieht, wenn eine Pufferung erforderlich ist. Bereits daraus wird ersichtlich, dass die Benutzung des Puffers nicht zwingend erforderlich ist, die Bereitstellung der Baugruppen jedoch erfolgen muss, wodurch ein zusätzlicher gerätetechnischer Aufwand entsteht. Im übrigen sind die bereits geschilderten Nachteile des FIFO-Puffers auch bei dieser Lösung festzustellen.

Um zu vermeiden, dass bei Rechnern mit Funktionseinheiten, welche einen hohen Datendurchsatz bewerkstelligen müssen, die CPU mit Speicherverwaltungsaufgaben stark beansprucht wird, ist es üblich, dass Direct Memory Access (DMA)-Einheiten angewendet werden, die diese Verwaltungsaufgaben übernehmen und den Speicher adress- und datenseitig selbst ansteuern können.

Nachteil dieser Lösung ist, dass ein hoher programmtechnischer Aufwand realisiert werden muss, um beim Betrieb mit mehreren Funktionseinheiten für die unter besonders zeitkritischen Bedingungen arbeitende Funktionseinheit, z.B. eine Prozessor-Einheit, den entsprechenden Vorrang beim Datenzugriff zu sichern. Weiterhin ist nachteilig, dass bei einer DMA-Anforderung immer eine bestimmte Zeitverzögerung bis zur Bereitstellung des erforderlichen Speicherzugriffes auftritt.

Der Erfindung liegt nunmehr die Aufgabe zu Grunde, einer zeitkritisch arbeitenden Funktionseinheit, z.B. einer Prozessor-Einheit, einen direkten Speicherzugriff zu ermöglichen, welcher weitestgehend verzögerungsfrei bereitsteht, und dabei Datenkollisionen vermieden werden, die bei einem Betrieb mit weiteren Funktionseinheiten z.B. einer I/O-Funktionseinheit mit direkten Speicherzugriff auftreten können.

Die erfindungsgemäße verfahrenseitige Lösung der Aufgabenstellung ist in dem unabhängigen Anspruch 1 definiert, und sieht vor, dass die Daten aus der I/O-Einheit in dem Prozessor-Speicher nur auf Adressen eines definierten Input-Speicherbereiches geschrieben werden, wobei die Adressierung durch die I/O-Einheit erfolgt. Von der Prozessor-Einheit werden die Daten aus dem Prozessor-Speicher nur von den Adressen des Input-Speicherbereiches gelesen, wobei die Adressierung durch die Prozessor-Einheit erfolgt. Die Daten aus der Prozessor-Einheit in dem ProzessorSpeicher werden nur auf Adressen eines definierten Output-Speicherbereiches geschrieben, wobei die Adressierung durch die Prozessor-Einheit erfolgt. Von der I/O-Einheit werden die Daten aus dem Prozessor-Speicher nur von den Adressen des Output-Speicherbereiches gelesen, wobei die Adressierung durch die I/O-Einheit erfolgt.

Hierbei wird durch eine direkte Zuordnung des Speicherbereiches zu den Funktionseinheiten ein verzögerungsfreier READ- bzw. WRITE- Speicherzugriff gewährleistet. Weiterhin werden mit der grundsätzlichen Vereinbarung zu den möglichen READ/WRITE-Zugriffen je Speicherbereich Daten-Kollisionen verhindert, indem damit der Verlauf der bidirektionalen Datenwege von I/O-Einheit und Prozessor-Einheit festgelegt werden.

Weiterhin wird es durch das erfindungsgemäße Verfahren möglich, unidirektionale Speicherbausteine mit zwei Ports zu nutzen, ohne auf flächenintensive Speicher mit bidirektional arbeitenden Ports zurückgreifen zu müssen.

Eine wichtige Variante der verfahrensseitigen Lösung der Aufgabenstellung sieht vor, dass die Datenzugriffe beim Lesen und Schreiben in den oder aus dem Input-Speicher-Bereich und in den oder aus dem Output-Speicher-Bereich des Prozessor-Speichers mittels der I/O-Einheit und mittels der Prozessor-Einheit jeweils eigenständig realisiert werden. Dadurch wird vermieden, dass die CPU mit Adressverwaltungsaufgaben beansprucht wird.

Eine spezielle Variante der verfahrensseitigen Lösung der Aufgabenstellung sieht vor, dass die Datenzugriffe beim Lesen und Schreiben in den oder aus dem Input-Speicher-Bereich und in den oder aus dem Output-Speicher-Bereich des Prozessor-Speichers mittels der I/O-Einheit und mittels der Prozessor-Einheit jeweils in einem Block mit einer solchen Blocklänge realisiert werden, die der Zeilenlänge der Prozessor-Speicherorganisation entspricht. Diese Lösung wird vorteilhaft angewendet, wenn häufig oder ausschließlich Datenzugriffe der Funktionseinheiten mit einer bestimmten Blocklänge vorgenommen werden. Auf diese Weise verringert sich die Zahl der Befehlsanweisungen, die von der CPU übermittelt werden müssen.

Die erfindungsgemäße anordnungsseitige Lösung der Aufgabenstellung ist in dem unabhängigen Anspruch 4 definiert und sieht vor, dass ein Datenport der Prozessor-Einheit mit einem ersten Datenport des Prozessor-Speichers verbunden ist und dass ein Datenport der I/O-Einheit mit einem zweiten Datenport des Prozessor-Speichers verbunden ist. Hierbei wird anordnungsseitig berücksichtigt, dass zur Realisierung der verfahrensseitigen Lösung der Aufgabenstellung eines direkten Datenzugriffs der I/O-Funktionseinheit und der Prozessor-Funktionseinheit auch ein entsprechendes Multi-Datenport des Prozessor-Speichers realisiert wird und dieses Multi-Datenport mit den entsprechenden Datenports der Funktionseinheiten in Verbindung steht.

Eine weitere erfindungsgemäße anordnungsseitige Lösung der Aufgabenstellung sieht vor, dass in der I/O-Einheit ein I/O-Adressgenerator und in der Prozessor-Einheit ein Prozessor-Adressgenerator angeordnet sind. Damit wird die eigenständige Fähigkeit der Adressierung der Datenzugriffe durch die o.g. Funktionseinheiten ermöglicht. Hierbei muss weiterhin realisiert sein, dass der Prozessor-Speicher auch mit einem Multi-Adressport ausgestattet wird und dass ein Adressport der Prozessor-Einheit mit einem ersten Adressport des Prozessor-Speichers verbunden ist und dass ein Adressport der I/O-Einheit mit einem zweiten Adressport des Prozessor-Speichers verbunden ist.

Weiterhin wird auch die READ/WRITE-Ansteuerung durch die Funktionseinheiten gewährleistet, indem am Prozessor-Speicher auch ein Multi-READ/WRITE-Port realisiert wird und ein READ/WRITE-Port der I/O-Einheit mit einem zweitem READ/WRITE-Port des Prozessor-Speichers geschalten ist, dass ein READ/WRITE-Port der Prozessor-Einheit mit einem ersten READ/WRITE-Port des Prozessor-Speichers geschalten ist.

Eine günstige erfindungsgemäße anordnungsseitige Lösung der Aufgabenstellung sieht vor, dass am I/O-Adressgenerator und am Prozessor-Adressgenerator jeweils ein Block-Längen-Port angeordnet ist. Damit wird eine Eingabemöglichkeit für die zu verarbeitenden Blocklängen der Datenzugriffe von I/O-Einheit und Prozessor-Einheit geschaffen.

Eine vorteilhafte erfindungsgemäße anordnungsseitige Lösung der Aufgabenstellung sieht vor, dass ein FIFO-Speicher in dem Prozessor-Speicher angeordnet ist. Da der Datenweg der Prozessor-Einheit direkt zum Prozessor-Speicher führt, wird ein als Zwischenpuffer fungierender FIFO-Speicher auch am Prozessor-Speicher angeordnet.

Die Erfindung soll nachfolgend an einem Ausführungsbeispiel erläutert werden. Aus der zugehörigen Zeichnungsfigur ist eine schematische Darstellung des Prozessor-Speichers 1 mit der zugeordneten Prozessor-Funktionseinheit 2 und der zugeordneten I/O-Funktionseinheit ersichtlich. Weiterhin ist in der Zeichnungsfigur ersichtlich, dass in der I/O-Funktionseinheit 3 ein I/O-Funktionseinheit-Adressport 11 angeordnet ist, welches mit dem zweiten Prozessor-Speicher-Adressport 13 verbunden ist, das wiederum auf dem Prozessor-Speicher 1 angeordnet ist. Das I/O-Funktionseinheit-Adressport 11 wird durch den I/O-Adressgenerator 15 angesteuert, dem durch das I/O-Blocklängen-Port 17 bei seiner Initialisierung die Blocklänge, d.h. die Anzahl der im Datenblock im Datenzugriff befindlichen, aufeinander folgenden Daten, mitgeteilt wird.

Bei einem angenommenen WRITE-Zustand der I/O-Funktionseinheit 3 gibt das auf ihr angeordnete I/O-READ/WRITE-Port 19 den WRITE-Zustand an das mit ihm verbundene zweite Prozessor-Speicher-READ/WRITE-Port 21 aus, welches auf dem Prozessor-Speicher 1 angeordnet ist. Die Adressen der schreibend von der I/O-Funktionseinheit 3 an den Prozessor-Speicher 1 zu übertragenden Datenblöcke liegen im vereinbarten Input-Speicherbereich 4 des Prozessor-Speichers 1. Sie werden vom I/O-Funktionseinheit-Adressport 11 an das mit ihm verbundene zweite Prozessor-Speicher-Adressport 13, welches auf dem Prozessor-Speicher 1 angeordnet ist, übermittelt. Auf diese Weise gelangen die mit diesen Adressen zugeordneten Daten von dem I/O-Funktionseinheit-Datenport 7, welches auf der I/O-Funktionseinheit 3 angeordnet ist, über das mit ihm verbundene und auf dem Prozessor-Speicher 1 angeordnete zweite Prozessor-Speicher-Datenport 9 und über den ebenfalls auf dem Prozessor-Speicher 1 angeordneten zweiten FIFO(First-In-First-Out)-Speicher 23 in den Input-Speicherbereich 4 des Prozessor-Speichers 1. Hier stehen die Daten zur weiteren Verarbeitung mit einem READ-Datenzugriff in der Prozessor-Funktionseinheit 2 bereit.

Der READ-Datenzugriff der Prozessor-Funktionseinheit 2 kann nur für den vereinbarten Adressbereich des Input-Speicherbereiches 4 erfolgen und die erforderlichen Adressen werden von dem Prozessor-Adressgenerator 14, welcher auf der Prozessor-Funktionseinheit angeordnet ist und der von dem dort ebenfalls angeordneten Prozessor-Blocklängen-Port 16 initialisiert wurde, bereitgestellt. Diese Adressen werden an das Prozessor-Funktionseinheit-Adressenport 10, welches auf der Prozessor-Funktionseinheit 2 angeordnet ist und das mit dem auf dem Prozessor-Speicher 1 angeordneten ersten Prozessor-Speicher-Adressport 12 verbunden ist, ausgegeben und steuern damit die adressierten Speicherzellen des Input-Speicherbereiches 4 an. Bei dem vorliegenden READ-Zustand der Prozessor-Funktionseinheit 2 gibt das auf ihr angeordnete Prozessor-READ/WRITE-Port 18 den READ-Zustand an das mit ihm in verbundene erste Prozessor-Speicher-READ/WRITE-Port 20 aus, welches auf dem Prozessor-Speicher 1 angeordnet ist. Voraussetzung für einen erfolgreichen READ-Datenzugriff der Prozessor-Funktionseinheit ist, dass die mit den angesteuerten Adressen zugeordneten Daten über den auf dem Prozessor-Speicher 1 angeordneten ersten FIFO-Speicher 22 und das ebenfalls auf dem Prozessor-Speicher 1 angeordnete erste Prozessor-Speicher-Datenport 8 und das mit ihm verbundene Prozessor-Funktionseinheit-Datenport 6, welches auf der Prozessor-Funktionseinheit 2 angeordnet ist, zur weiteren Verarbeitung in der Prozessor-Funktionseinheit 2 bereitgestellt werden.

Der Komplementärvorgang des WRITE-Datenzugriffs der Prozessor-Funktionseinheit 2 und des READ-Datenzugriffs der I/O-Funktionseinheit 3 erfolgt in analoger Weise des bezüglich des Input-Speicherbereiches 4 beschriebenen WRITE-Datenzugriffs der I/O-Funktionseinheit 3 und des READ-Datenzugriffs der Prozessor-Funktionseinheit 2 unter Berücksichtigung der hierbei vorliegenden Vereinbarung, dass alle im Datenzugriff befindlichen Speicherzellen des Prozessor-Speichers 1 sich nunmehr im Output-Speicherbereich 5 befinden und nur diese entsprechenden Adressen von den Adressgeneratoren 14 und 15 bereitgestellt werden.

### Bezugzeichenliste

- 1: Prozessor-Speicher
- 2: Prozessor-Funktionseinheit
- 3: I/O-Funktionseinheit
- 4: Input-Speicherbereich
- 5: Output-Speicherbereich
- 6: Prozessor-Funktionseinheit-Datenport
- 7: I/O-Funktionseinheit-Datenport
- 8: erstes Prozessor-Speicher-Datenport
- 9: zweites Prozessor-Speicher-Datenport
- 10: Prozessor-Funktionseinheit-Adressport
- 11: I/O-Funktionseinheit-Adressport
- 12: erstes Prozessor-Speicher-Adressport
- 13: zweites Prozessor-Speicher-Adressport
- 14: Prozessor-Adressgenerator
- 15: I/O-Adressgenerator
- 16: Prozessor-Blocklängen-Port
- 17: I/O-Blocklängen-Port
- 18: Prozessor-READ/WRITE-Port
- 19: I/O-RFAD/WRITE-Port
- 20: erstes Prozessor-Speicher-READ/WRITE-Port
- 21: zweites Prozessor-Speicher-READ/WRITE-Port
- 22: erster FIFO-Speicher
- 23: zweiter FIFO-Speicher

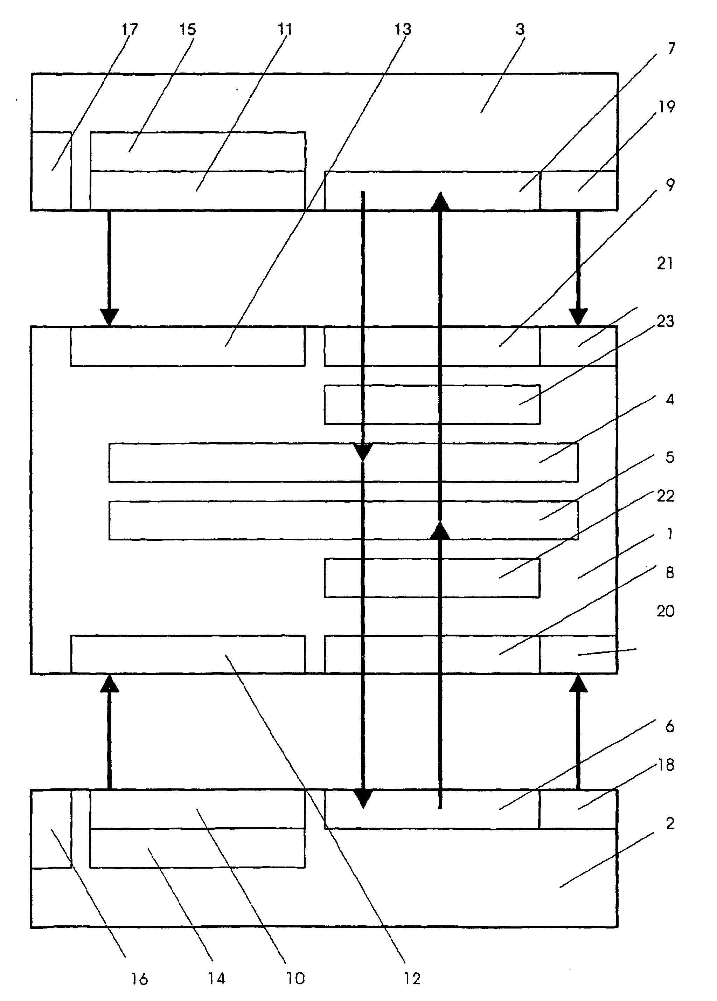

## Patentansprüche

1. Verfahren zur Datenein- und -ausgabe bei einem Prozessor-Speicher, bei dem Daten aus einer Prozessor-Einheit in den Prozessor-Speicher geschrieben und aus diesem Prozessor-Speicher gelesen werden und die Daten über eine I/O-Einheit ein- und ausgegeben werden, **dadurch gekennzeichnet, dass** die Daten aus der I/O-Einheit (3) über ein I/O-Einheit-Datenport (7) und ein angeschlossenes zweites Prozessor-Speicher-Datenport (9) in dem ProzessorSpeicher (1) nur auf Adressen eines definierten Input-Speicherbereiches (4) bei Übermittlung eines WRITE-Zustandes über ein I/O-READ/WRITE-Port (19) an ein angeschlossenes zweites Prozessor-Speicher-READ/WRITE-Port (21) geschrieben werden, wobei die Adressierung über ein I/O-Einheit-Adressport (11) und ein angeschlossenes zweites Prozessor-Speicher-Adressport 13) durch die I/O-Einheit (3) erfolgt, und von der Prozessor-Funktionseinheit (2) die Daten aus dem Prozessor-Speicher (1) nur von den Adressen des Input-Speicherbereiches (4) über ein erstes Prozessor-Speicher-Datenport (8) und ein angeschlossenes Prozessor-Funktionseinheit-Datenport (6) bei Übermittlung eines READ-Zustandes über ein Prozessor-READ/WRITE-Port (18) an ein angeschlossenes erstes Prozessor-Speicher-READ/WRITE-Port (20) gelesen werden, wobei die Adressierung über ein Prozessor-Funktionseinheit-Adressport (10) und ein angeschlossenes erstes Prozessor-Speicher-Adressport (12) durch die Prozessor-Funktionseinheit (2) erfolgt und
die Daten aus der Prozessor-Funktionseinheit (2) über das Prozessor-Funktionseinheit-Datenport (6) und das angeschlossene erste Prozessor-Speicher-Datenport (8) bei Übermittlung eines WRITE-Zustandes über das Prozessor-READ/WRITE-Port (18) an das angeschlossene erste Prozessor-Speicher-READ/WRITE-Port (20) in dem Prozessor-Speicher (1) nur auf Adressen eines definierten Output-Speicherbereiches (5) geschrieben werden, wobei die Adressierung über das Prozessor-Funktionseinheit-Adressport (10) und das angeschlossene erste Prozessor-Speicher-Adressport (12) durch die Prozessor-Funktionseinheit (2) erfolgt, und von der I/O-Funktionseinheit (3) die Daten über das zweite Prozessor-Speicher-Datenport (9) und das angeschlossene I/O-Einheit-Datenport (7) bei Übermittlung eines READ-Zustandes über das I/O-READ/WRITE-Port (19) an das angeschlossene zweite Prozessor-Speicher-READ/WRITE-Port (21) aus dem Prozessor-Speicher (1) nur von den Adressen des Output-Speicherbereiches (5) gelesen werden, wobei die Adressierung über das I/O-Einheit-Adressport (11) und das angeschlossene zweite Prozessor-Speicher-Adressport 13) durch die I/O-Funktionseinheit (3) erfolgt.

2. Verfahren nach Anspruch 1 **dadurch gekennzeichnet, dass** die Datenzugriffe beim Lesen und Schreiben in den Input-Speicherbereich (4) und Output-Speicher-Bereich (5) des Prozessor-Speichers (1) mittels der I/O-Funktionseinheit (3) und mittels der Prozessor-Funktionseinheit (2) jeweils eigenständig realisiert werden.

3. Verfahren nach Anspruch 2 **dadurch gekennzeichnet, dass** die Datenzugriffe beim Lesen und Schreiben in den Input-Speicherbereich (4) und Output-Speicherbereich (5) des Prozessor-Speichers (1) mittels der I/O-Funktionseinheit (3) und mittels der Prozessor-Funktionseinheit (2) jeweils in einem Block mit einer solchen Blocklänge realisiert werden, die der Zeilenlänge der Prozessor-Speicherorganisation entspricht.

4. Anordnung mit Mitteln zur Durchführung der Schritte des Verfahrens nach Anspruch 1 **dadurch gekennzeichnet, dass** der Prozessor-Funktionseinheit-Datenport (6) mit einem ersten Prozessor-Speicher-Datenport (8) verbunden ist und dass der I/O-Funktionsseinheit-Datenport (7) mit einem zweiten Prozessor-Speicher-Datenport verbunden (9) ist.

5. Anordnung nach Anspruch 4 **dadurch gekennzeichnet, dass** in der I/O-Funktionseinheit (3) ein I/O-Adressgenerator (15) und in der Prozessor-Funktionseinheit (2) ein Prozessor-Adressgenerator (14) angeordnet sind, dass ein Prozessor-Funktionseinheit-Adressport (10) mit einem ersten Prozessor-Speicher-Adressport (12) verbunden ist, dass ein I/O-Funktionseinheit-Adressport- (11) mit einem zweiten Prozessor-Speicher-Adressport (13) verbunden ist, dass ein I/O-R-EAD/WRITE-Port (19) der I/O-Funktionseinheit (3) mit einem zweitem Prozessor-Speicher-READ/WRITE-Port (21) des Prozessor-Speichers (1) geschalten ist, dass ein Prozessor-READ/WRITE-Port (18) der Prozessor-Funktionseinheit (2) mit einem ersten Prozessor-Speicher-READ/WRITE-Port (20) des Prozessor-Speichers (1) geschalten ist.

6. Anordnung nach Anspruch 5 **dadurch gekennzeichnet, dass** am I/O-Adressgenerator (15) ein I/O-Blocklängen-Port (17) und am Prozessor-Adressgenerator (14) ein Prozessor-Blocklängen-Port (16) angeordnet ist.

7. Anordnung nach Ansprüchen 4 bis 6 **dadurch gekennzeichnet, dass** ein erster FIFO-Speicher (22) und ein zweiter FIFO-Speicher (23) in dem Prozessor-Speicher (1) angeordnet sind.

## Claims

1. Method for inputting and outputting data in a processor memory, in which data are written to the processor memory from a processor unit and are read from this processor memory, and the data are input and output via an I/O unit, **characterized in that** the data from the I/O unit (3) are written, via an I/O unit data port (7) and a connected second processor memory data port (9) in the processor memory (1), only to addresses of a defined input memory area (4) while a write state is being transmitted, via an I/O read/write port (19), to a connected second processor memory read/write port (21), the I/O unit (3) carrying out addressing via an I/O unit address port (11) and a connected second processor memory address port (13), and **in that** the processor functional unit (2) reads the data only from the addresses of the input memory area (4) of the processor memory (1), via a first processor memory data port (8) and a connected processor functional unit data port (6), while a read state is being transmitted, via a processor read/write port (18), to a connected first processor memory read/write port (20), the processor functional unit (2) carrying out addressing via a processor functional unit address port (10) and a connected first processor memory address port (12), and **in that** the data from the processor functional unit (2) are written, via the processor functional unit data port (6) and the connected first processor memory data port (8), only to addresses of a defined output memory area (5) while a write state is being transmitted, via the processor read/write port (18), to the connected first processor memory read/write port (20) in the processor memory (1), the processor functional unit (2) carrying out addressing via the processor functional unit address port (10) and the connected first processor memory address port (12), and **in that** the I/O functional unit (3) reads the data only from the addresses of the output memory area (5) of the processor memory (1), via the second processor memory data port (9) and the connected I/O unit data port (7), while a read state is being transmitted, via the I/O read/write port (19), to the connected second processor memory read/write port (21), the I/O functional unit (3) carrying out addressing via the I/O unit address port (11) and the connected second processor memory address port (13).

2. Method according to Claim 1, **characterized in that** the data access operations when reading from, and writing to, the input memory area (4) and output memory area (5) of the processor memory (1) are respectively performed independently using the I/O functional unit (3) and the processor functional unit (2).

3. Method according to Claim 2, **characterized in that** the data access operations when reading from, and writing to, the input memory area (4) and output memory area (5) of the processor memory (1) are respectively performed in a block (which has a block length that corresponds to the row length of the processor memory organization) using the I/O functional unit (3) and the processor functional unit (2).

4. Arrangement having means for carrying out the steps of the method according to Claim 1, **characterized in that** the processor functional unit data port (6) is connected to a first processor memory data port (8), and **in that** the I/O functional unit data port (7) is connected to a second processor memory data port (9).

5. Arrangement according to Claim 4, **characterized in that** an I/O address generator (15) is arranged in the I/O functional unit (3) and a processor address generator (14) is arranged in the processor functional unit (2), **in that** a processor functional unit address port (10) is connected to a first processor memory address port (12), **in that** an I/O functional unit address port (11) is connected to a second processor memory address port (13), **in that** an I/O read/write port (19) of the I/O functional unit (3) is connected to a second processor memory read/write port (21) of the processor memory (1), and **in that** a processor read/write port (18) of the processor functional unit (2) is connected to a first processor memory read/write port (20) of the processor memory (1).

6. Arrangement according to Claim 5, **characterized in that** an I/O block length port (17) is arranged at the I/O address generator (15) and a processor block length port (16) is arranged at the processor address generator (14).

7. Arrangement according to Claims 4 to 6, **characterized in that** a first FIFO memory (22) and a second FIFO memory (23) are arranged in the processor memory (1).

## Revendications

1. Procédé d'entrée et de sortie de données pour une mémoire de processeur, dans lequel des données provenant d'une unité de processeur sont inscrites dans la mémoire de processeur et sont lues à partir de cette mémoire de processeur, et les données sont entrées et sorties par l'intermédiaire d'une unité E/S,
**caractérisé en ce que**
les données provenant de l'unité E/S (3) sont écrites dans la mémoire de processeur (1) par l'intermédiaire d'un port de données E/S (7) et d'un deuxième port de données de la mémoire de processeur (9) raccordé, uniquement sur des adresses d'une zone de mémoire d'entrée définie (4), lors de la transmission d'un état ECRITURE par l'intermédiaire d'un port LECTURE/ECRITURE-E/S (19) à un deuxième port LECTURE/ECRITURE de la mémoire de processeur (21) raccordé, l'adressage étant effectué par l'unité E/S (3) par l'intermédiaire d'un port d'adresse de l'unité E/S (11) et d'un deuxième port d'adresse de la mémoire de processeur (13) raccordé, et les données provenant de la mémoire de processeur (1) sont lues par l'unité fonctionnelle de processeur (2) uniquement sur des adresses de la zone de mémoire d'entrée (4) par l'intermédiaire d'un premier port de données de la mémoire de processeur (8) et d'un port de données de l'unité fonctionnelle de processeur (6) raccordé, lors de la transmission d'un état LECTURE par l'intermédiaire d'un port LECTURE/ECRITURE du processeur (18) à un premier port LECTURE/ECRITURE de la mémoire de processeur (20) raccordé, l'adressage étant effectué par l'unité fonctionnelle de processeur (2) par l'intermédiaire d'un port d'adresse de l'unité fonctionnelle de processeur (10) et d'un premier port d'adresse de la mémoire de processeur (12) raccordé, et
les données provenant de l'unité fonctionnelle de processeur (2) sont écrites dans la mémoire du processeur (1) par l'intermédiaire du port de données de l'unité fonctionnelle de processeur (6) et du premier port de données de la mémoire de processeur (8) raccordé, lors de la transmission d'un état ECRITURE par l'intermédiaire du port LECTURE/ECRITURE du processeur (18) au premier port LECTURE/ECRITURE de la mémoire de processeur (20) raccordé, uniquement sur des adresses d'une zone de mémoire de sortie définie (5), l'adressage étant effectué par l'unité fonctionnelle de processeur (2) par l'intermédiaire du port d'adresse de l'unité fonctionnelle de processeur (10) et du premier port d'adresse de la mémoire de processeur (12) raccordé, et les données sont lues à partir de la mémoire de processeur (1) par l'unité fonctionnelle E/S (3), par l'intermédiaire du deuxième port de données de la mémoire de processeur (9) et du port de données de l'unité E/S (7) raccordé, lors de la transmission d'un état LECTURE par l'intermédiaire du port LECTURE/ECRITURE-E/S (19) au deuxième port LECTURE/ECRITURE de la mémoire de processeur (21) raccordé, uniquement sur les adresses de la zone de mémoire de sortie (5), l'adressage étant effectué par l'unité fonctionnelle E/S (3) par l'intermédiaire du port d'adresse de l'unité E/S (11) et du deuxième port d'adresse de la mémoire de processeur (13) raccordé.

2. Procédé selon la revendication 1,
**caractérisé en ce que**
les accès aux données lors de la lecture et de l'écriture dans la zone de mémoire d'entrée (4) et dans la zone de mémoire de sortie (5) de la mémoire de processeur (1) sont réalisés respectivement de façon autonome au moyen de l'unité fonctionnelle E/S (3) et au moyen de l'unité fonctionnelle de processeur (2).

3. Procédé selon la revendication 2,
**caractérisé en ce que**
les accès aux données lors de la lecture et de l'écriture dans la zone de mémoire d'entrée (4) et dans la zone de mémoire de sortie (5) de la mémoire de processeur (1) sont réalisés au moyen de l'unité fonctionnelle E/S (3) et au moyen de l'unité fonctionnelle de processeur (2) respectivement en un bloc avec une longueur de bloc correspondant à la longueur de ligne de la structure de la mémoire de processeur.

4. Dispositif comprenant des moyens permettant de mettre en oeuvre les étapes du procédé selon la revendication 1,
**caractérisé en ce que**
le port de données de l'unité fonctionnelle de processeur (6) est relié à un premier port de données de la mémoire de processeur (8) et le port de données de l'unité fonctionnelle E/S (7) est relié à un deuxième port de données de la mémoire de processeur (9).

5. Dispositif selon la revendication 4,
**caractérisé en ce que**
l'unité fonctionnelle E/S (3) comprend un générateur d'adresse E/S (15) et l'unité fonctionnelle de processeur (2), un générateur d'adresse de processeur (14),
un port d'adresse de l'unité fonctionnelle de processeur (10) est relié à un premier port d'adresse de la mémoire de processeur (12),
un port d'adresse de l'unité fonctionnelle E/S (11) est relié à un deuxième port d'adresse de la mémoire de processeur (13),
un port LECTURE/ECRITURE-E/S (19) de l'unité fonctionnelle E/S (3) est relié à un deuxième port LECTURE/ECRITURE (21) de la mémoire de processeur (1),
un port LECTURE/ECRITURE de processeur (18) de l'unité fonctionnelle de processeur (2) est relié à un premier port LECTURE/ECRITURE (20) de la mémoire de processeur (1).

6. Dispositif selon la revendication 5,
**caractérisé en ce que**
le générateur d'adresse E/S (15) comporte un port de longueur de bloc E/S (17) et le générateur d'adresse de processeur (14) comporte un port de longueur de bloc de processeur (16).

7. Dispositif selon les revendications 4 à 6,
**caractérisé par**
une première mémoire FIFO (22) et une seconde mémoire FIFO (23) prévues dans la mémoire de processeur (1).
